Europäisches Patentamt

European Patent Office

Office européen des brevets

(19)

(11) Numéro de publication : **0 159 072**
**B1**

(12) **FASCICULE DE BREVET EUROPÉEN**

(45) Date de publication du fascicule du brevet :
07.06.89

(51) Int. Cl.⁴ : **H 03 L 7/00**

(21) Numéro de dépôt : 85200446.4

(22) Date de dépôt : 25.03.85

(54) **Comparateur de phase à fonctionnement linéarisé et boucle à verrouillage de phase comprenant un tel comparateur de phase.**

(30) Priorité : 30.03.84 FR 8405024

(43) Date de publication de la demande :
23.10.85 Bulletin 85/43

(45) Mention de la délivrance du brevet :
07.06.89 Bulletin 89/23

(84) Etats contractants désignés :
DE FR GB

(56) Documents cités :
DE--A-- 1 466 080
US--A-- 4 145 663
PROCEEDINGS OF THE SYMPOSIUM ON COMPUTER PROCESSING IN COMMUNICATIONS, New York, 8-10 avril 1969, pages 343-357, Polytechnic Press, Brooklyn, N.Y., US; W.E. LARIMORE: "Design and performance of a second order digital phase-locked loop"

(73) Titulaire : **Laboratoires d'Electronique et de Physique Appliquée L.E.P.**
**3, Avenue Descartes**
**F-94450 Limeil-Brévannes (FR)**
**FR**
**N.V. Philips' Gloeilampenfabrieken**
**Groenewoudseweg 1**
**NL-5621 BA Eindhoven (NL)**
**DE GB**

(72) Inventeur : **Le Queau, Marcel**
**Société Civile S.P.I.D. 209 rue de l'Université**
**F-75007 Paris (FR)**

(74) Mandataire : **Landousy, Christian et al**
**Société Civile S.P.I.D. 209, Rue de l'Université**
**F-75007 Paris (FR)**

Jouve, 18, rue St-Denis, 75001 Paris, France

## Description

La présente invention concerne un comparateur de phase recevant un signal sinusoïdal d'entrée de phase $\phi_E$ et un signal sinusoïdal de phase $\phi_S$ à comparer à ce signal d'entrée, ainsi qu'une boucle à verrouillage de phase comprenant un comparateur de phase, un filtre de boucle et un oscillateur, respectivement pour mesurer la différence de phase entre un signal d'entrée et le signal de sortie de l'oscillateur, pour transmettre à l'oscillateur ladite différence de phase en la filtrant, et pour délivrer vers le comparateur de phase un signal dont la fréquence est corrigée dans le sens d'une diminution de ladite différence de phase.

Le brevet des Etats-Unis d'Amérique US-A-3 997 848 décrit un démodulateur composé notamment d'une boucle à verrouillage de phase dont le comparateur de phase a un fonctionnement linéarisé à l'aide d'une boucle auxiliaire. Mais l'effet de celle-ci est de réduire l'indice de modulation d'un modulateur présent en amont d'une des entrées du comparateur (l'entrée de la boucle principale), et non de modifier, comme dans le cas de l'invention, la dynamique du comparateur sans intervenir sur le signal d'entrée du comparateur, à l'aide d'une boucle auxiliaire qui peut en outre n'être composée que d'éléments passifs.

Un premier but de l'invention est donc de proposer un comparateur de phase dont le fonctionnement est également linéarisé mais par d'autres moyens.

A cet effet, le comparateur de phase selon l'invention est caractérisé en ce qu'il lui est associé un étage auxiliaire composé d'une part de moyens de réduction d'une valeur déterminée de la différence de phase entre les deux entrées du comparateur et d'autre part de moyens de restitution de ladite valeur en sortie dudit étage auxiliaire ledit étage auxiliaire recevant la sortie du comparateur et le signal à comparer et délivrant d'une part un signal de sortie desdits moyens de restitution, et d'autre part, pour rebouclage, un signal de sortie desdits moyens de réduction de différence de phase.

Un autre but de l'invention est de proposer une boucle à verrouillage de phase comprenant un tel comparateur de phase à fonctionnement linéarisé. En effet, au-delà d'une certaine valeur de différence de phase, le comparateur ne peut plus mesurer cette différence avec précision à cause de non-linéarités de sa fonction de transfert. Il en résulte une dégradation des performances de la boucle, qui risque même de ne plus parvenir à se verrouiller sur le signal d'entrée.

A cet effet, la boucle selon l'invention est alors caractérisée en ce que le comparateur de phase est conforme à la revendication 1.

Les particularités et avantages de l'invention apparaîtront maintenant de façon plus détaillée dans la description qui suit et dans les dessins annexés, donnés à titre d'exemples et dans lesquels :

— la figure 1 montre un premier exemple de réalisation de l'invention, dans lequel un étage auxiliaire de réduction de dynamique est associé à un comparateur de phase ;

— la figure 2 montre un exemple de boucle à verrouillage de phase équipée d'un tel étage auxiliaire ;

— la figure 3 montre, dans le cas où la boucle selon l'invention fait partie d'un démodulateur de fréquence pour récepteur de télévision selon le standard SECAM, le filtre nécessaire pour obtenir finalement le signal de différence de couleur désaccentué.

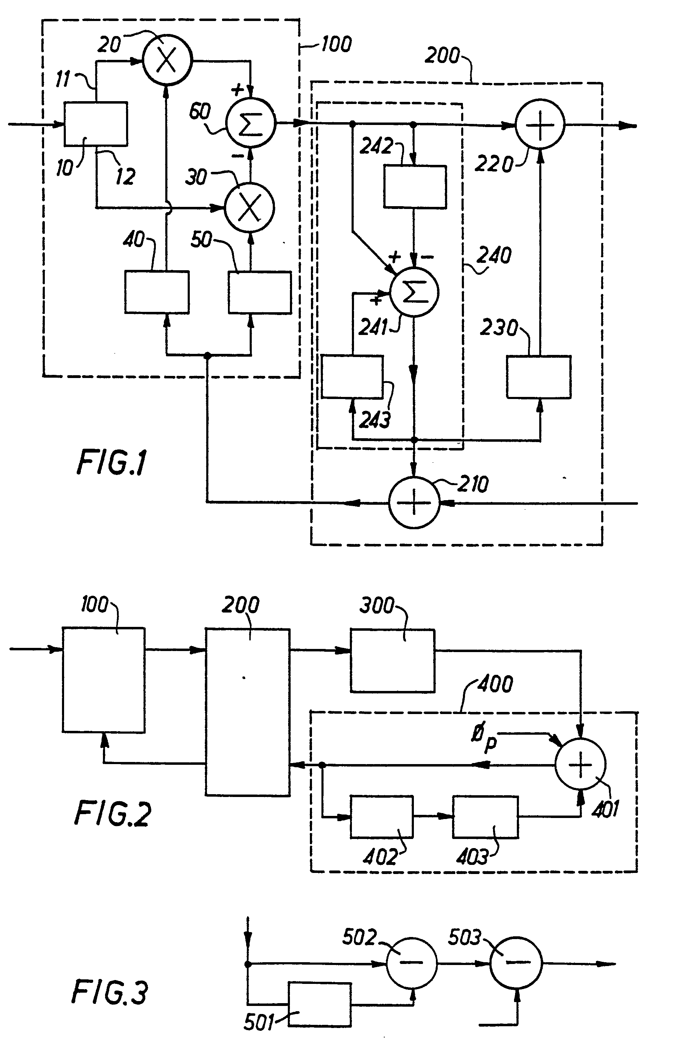

Le comparateur de phase 100 représenté dans un mode particulier de réalisation sur la figure 1 comprend ici un filtre de quadrature 10 qui reçoit le signal d'entrée et délivre sur une sortie 11 ce signal d'entrée retardé, dont la phase est notée $\phi_E$, et sur une sortie 12 ce même signal retardé mais déphasé de $\pi/2$ et dont la phase est donc notée $\phi_E + \pi/2$. Les sorties 11 et 12 sont reliées aux premières entrées respectives de deux multiplieurs 20 et 30 dont les deuxièmes entrées reçoivent les sorties respectives de deux mémoires mortes 40 et 50 dont l'adressage est commun et qui sont commandées directement par le signal auquel va être comparé le signal de phase $\phi_E$. Ces mémoires 40 et 50 transforment l'information de phase $\phi$ présente sur cette entrée commune respectivement en l'expression $\sin(\phi + \pi/2)$ et l'expression $\sin \phi$. Un sommateur 60 reçoit sur son entrée positive la sortie du multiplieur 20 et sur son entrée négative celle du multiplieur 30 ; et délivre un signal $\sin \phi_E \cdot \cos \phi - \cos \phi_E \cdot \sin \phi = \sin(\phi_E - \phi)$, c'est-à-dire par approximation $\phi_E - \phi$ lorsque cette différence est faible.

A ce comparateur 100 est associé un étage auxiliaire 200, dit boucle auxiliaire de réduction de dynamique et composé d'une part d'un additionneur 210 recevant des entrées $\phi_S$ et $\phi_0$ et transmettant au comparateur 100 la somme $(\phi_S + \phi_0)$, d'autre part d'un additionneur 220 recevant la sortie du comparateur 100 et y ajoutant l'entrée $\phi_0$ de l'additionneur 210 retardée par un circuit à retard 230, et enfin d'un circuit 240 engendrant le signal $\phi_0$ fourni directement à l'additionneur 210 et par l'intermédiaire du circuit 230 à l'additionneur 220. Ce circuit 240 comprend un sommateur 241 recevant sur une première entrée positive directement la sortie du comparateur 100, sur une deuxième entrée négative cette même sortie du comparateur 100 mais après traversée d'un filtre 242, et sur une troisième entrée positive sa propre sortie $\phi_0$ mais retardée par un circuit à retard 243.

Le fonctionnement de ce mode de réalisation du comparateur 100 équipé de l'étage auxiliaire 200 de réduction de dynamique est le suivant. Sur l'entrée du comparateur 100 qui recevrait en l'absence de l'étage 200 l'information $\phi_S$, on ajoute une information $\phi_0$ qui, ajoutée à $\phi_S$, va

diminuer la différence de phase mesurée par le comparateur et qui est évaluée, comme indiqué dans le paragraphe précédent, principalement à partir de la sortie dudit comparateur, dans le circuit 240. Le comparateur de phase délivre alors une information qui, au lieu d'être du type $\sin(\phi_E - \phi_S)$, est du type $\sin(\phi_E - \phi_S - \phi_0)$. Il ne reste plus alors, pour rétablir l'exactitude du résultat fourni par le comparateur 100, qu'à lui ajouter l'information $\phi_0$ qui avait artificiellement réduit d'autant la différence de phase à mesurer.

Le comparateur ainsi proposé peut être notamment introduit dans une boucle à verrouillage de phase, par exemple de type numérique, telle que celle représentée sur la figure 2. Cette boucle numérique comprend ici le comparateur 100, l'étage auxiliaire 200, un filtre de boucle 300 et un oscillateur 400 commandé numériquement. Le comparateur 100 mesure la différence de phase existant entre le signal d'entrée de phase $\phi_E$ sur lequel doit se verrouiller la boucle et le signal de phase $(\phi_S + \phi_0)$ fourni sur son autre entrée. Le filtre de boucle 300 transmet à l'oscillateur 400 la différence de phase obtenue en sortie du comparateur 100 et corrigée par action de l'étage 200. Le signal ainsi transmis à l'oscillateur 400 modifie la fréquence de celui-ci de façon que la différence de phase diminue, ce processus assurant le verrouillage de la boucle sur le signal de phase $\phi_E$.

Le comparateur 100 et l'étage 200 comprennent les mêmes éléments que précédemment. Le filtre de boucle 300 est un filtre passe-bas. L'oscillateur 400 est du type à accumulateur et comprend un additionneur 401 recevant sur une première entrée sa propre sortie après traversée d'un circuit à retard 402 et d'un filtre 403 identique au filtre de boucle 300, sur une deuxième entrée la sortie du filtre de boucle 300, et sur une troisième entrée une constante d'accumulation $\phi_P$ représentant l'incrément de phase. Les retards apportés par les circuits à retard 243 et 402 sont égaux à un nombre entier de périodes d'échantillonnage, en général une période.

Une boucle à verrouillage de phase possédant cette structure présente en matière de stabilité, de précision, de rapidité et de bande de fréquence des performances meilleures que celles obtenues avec la même boucle non équipée de l'étage auxiliaire 200. Dans le cas décrit d'une boucle dont le comparateur de phase est à double multiplieur, la linéarisation du fonctionnement du comparateur permet à cette boucle de travailler pratiquement dans toute la bande de Nyquist (à l'exclusion de la fréquence nulle, de la demi-fréquence d'échantillonnage et des fréquences voisines de ces deux fréquences). De plus, une telle boucle, utilisée dans un démodulateur de fréquence, présente une extension de seuil souvent supérieure à celle obtenue avec des boucles à verrouillage de phase analogiques ; en effet, alors qu'en analogique la valeur minimale du gain de boucle est limitée par les dérives à long terme des composants, pour une boucle numérique ce gain peut prendre la valeur optimale 1 (c'est-à-dire que, la boucle étant ouverte, un déphasage

continu $\Delta\phi$ à son entrée provoque un déphase continu $-\Delta\phi$ en sortie de l'oscillateur).

Bien entendu, la présente invention n'est pas limitée aux exemples de réalisation décrits et représentés à partir desquels des variantes peuvent être proposées sans pour cela sortir du cadre de l'invention. On notera en particulier que, dans le cas décrit d'une boucle numérique, le filtre de boucle est un filtre numérique, et que ce filtre, voire la boucle entière, peut, si la fréquence d'échantillonnage n'est pas trop élevée, être remplacé par un microprocesseur exécutant les mêmes fonctions.

On remarque aussi que la valeur de différence de phase obtenue en sortie du comparateur 100 est minimale quand la fonction de transfert du filtre auxiliaire 242 est égale à celle de la boucle, en boucle fermée, et que le retard apporté par le circuit à retard 230 est limité à une période d'échantillonnage. Cependant, comme en pratique on recherche non pas nécessairement l'obtention d'une valeur minimale mais seulement le maintien de la mesure effectuée par le comparateur à l'intérieur d'une certaine dynamique, cette fonction de transfert du filtre 242 peut n'être qu'une approximation de celle cité ci-dessus, et le retard apporté par le circuit 230 peut être supérieur à une période.

Par ailleurs, dans le cas d'un démodulateur de l'information couleur dans un récepteur de télévision de type SECAM, on choisit de préférence pour le filtre de boucle 300, le filtre 242 et le filtre 403 une fonction de transfert identique et égale à celle du filtre de désaccentuation défini dans le codage SECAM, mais ces fonctions de transfert du filtre 403 peuvent chacune n'être qu'une approximation de celle souhaitée. Dans tous les cas, le signal de différence de couleur désaccentué est obtenu après traversée d'un filtre représenté sur la figure 3, placé en sortie de l'oscillateur 400 et composé d'un circuit à retard 501 et de deux soustracteurs 502 et 503 : la sortie du premier soustracteur 502 donne la différence de phase entre deux échantillons en général successifs du signal de sortie de l'oscillateur, tandis que le deuxième soustracteur 503 soustrait de cette différence la constante d'accumulation $\phi_P$, qui représente ici l'incrément de phase de la sous-porteuse couleur entre deux échantillons successifs, et délivre ainsi un signal proportionnel au signal de différence couleur. On notera bien évidemment que ces dernières remarques s'appliquent aussi dans le cas d'un récepteur multistandard, ou même utilisant le standard C-MAC paquets.

## Revendications

1. Comparateur de phase (100) recevant un signal sinusoïdal d'entrée de phase $\phi_E$ et un signal sinusoïdal de phase $\phi_S$ à comparer à ce signal d'entrée, caractérisé en ce qu'il lui est associé un étage auxiliaire (200) composé d'une part de moyens (210, 240) de réduction d'une valeur déterminée de la différence de phase entre les deux entrées du comparateur (100) et d'autre part de moyens de restitution (220, 230) de ladite valeur en sortie dudit étage auxiliaire (200), ledit étage auxiliaire (200) recevant la sortie du comparateur (100) et le signal à comparer et délivrant d'une part un signal de sortie desdits moyens de restitution (220, 230) et d'autre part, pour rebouclage, un signal de sortie desdits moyens (210, 240) de réduction de différence de phase.

2. Boucle à verrouillage de phase comprenant un comparateur de phase, un filtre de boucle (300) et un oscillateur (400), respectivement pour mesurer la différence de phase entre un signal d'entrée et le signal de sortie de l'oscillateur, pour transmettre à l'oscillateur ladite différence de phase en la filtrant, et pour délivrer vers le comparateur de phase un signal dont la fréquence est corrigée dans le sens d'une diminution de ladite différence de phase, caractérisée en ce que le comparateur de phase équipé de son étage auxiliaire (200) est conforme à la revendication 1.

3. Boucle à verrouillage de phase selon la revendication 2, caractérisée en ce que les moyens de réduction de la différence de phase comprennent un premier additionneur (210) recevant d'une part un signal d'entrée $\phi_S$ fourni par l'oscillateur et d'autre part un signal $\phi_0$ de réduction de différence de phase et transmettant au comparateur la grandeur $(\phi_S + \phi_0)$, en ce que les moyens de restitution comprennent un deuxième additionneur (220) recevant sur une première entrée la sortie du comparateur (100) et sur une deuxième entrée le signal $\phi_0$ d'entrée dudit premier additionneur, par l'intermédiaire de moyens de retardement dudit signal $\phi_0$.

4. Boucle à verrouillage de phase selon la revendication 3, caractérisée en ce que le signal $\phi_0$ est fourni par un circuit de génération comprenant un sommateur (241) dont une première entrée positive est reliée directement à la sortie du comparateur (100), dont une deuxième entrée négative est reliée également à la sortie du comparateur (100) mais par l'intermédiaire d'un filtre auxiliaire (242), et dont une troisième entrée positive est reliée à la sortie du sommateur par l'intermédiaire d'un circuit à retard (243), le signal $\phi_0$ étant disponible sur la sortie dudit sommateur (241).

5. Boucle à verrouillage de phase selon la revendication 4, caractérisée en ce qu'elle est numérique, en ce que la fonction de transfert du filtre auxiliaire (242) est égale à, ou constitue une approximation de celle de la boucle, en boucle fermée, et en ce que le retard apporté par le circuit à retard (243) est égal à un nombre entier de périodes d'échantillonnage.

6. Boucle à verrouillage de phase selon la revendication 5, caractérisée en ce que le filtre de boucle (300) est un microprocesseur.

7. Boucle à verrouillage de phase selon la revendication 6, caractérisée en ce que le microprocesseur contrôle l'exécution de l'ensemble des fonctions de ladite boucle.

**Claims**

1. A phase comparator receiving a sinusoidal input signal of phase $\varphi_E$ and a sinusoidal signal of phase $\varphi_S$ to be compared with this input signal, characterized in that associated therewith is an auxiliary stage (200) comprising means (210, 240) for reducing the phase difference between the two inputs of the comparator (100) by a predetermined value and also means (220, 230) for recovering said value at the output of the auxiliary sate (200), said auxiliary stage (200) receiving the ouput from the comparator (100) and the signal to be compared and supplying an output signal of said recovering means (220, 230) and also, for feedback purposes, an output signal of said phase difference reducing means (210, 240).

2. A phase-locked loop comprising a phase comparator, a loop filter (300) and an oscillator (400), for respectively measuring the phase difference between an input signal and the output signal of the oscillator, for conveying to the oscillator said phase difference by filtering it, and for applying to the phase comparator a signal whose frequency is corrected in that said phase difference is reduced, characterized in that the phase comparator provided with its auxiliary stage (200) is in conformity with Claim 1.

3. A phase-locked loop as claimed in claim 2, characterized in that the phase difference reducing means comprise a first adder (210) receiving an input signal $\varphi_S$ supplied by the oscillator and also a signal $\varphi_0$ for reducing the phase difference and conveying to the comparator the quantity $(\varphi_S + \varphi_0)$, and that the recovering means have a second adder (220) which at a first input receives the output from the comparator (100) and at a second input receives the input signal $\varphi_0$ from said first adder, via means for delaying said signal $\varphi_0$.

4. A phase-locked loop as claimed in claim 3, characterized in that the signal $\varphi_0$ is produced by a generating circuit comprising a summing device (241) a first positive input of which is connected directly to the output of the comparator (100), a second, negative input of which is also connected to the output of the comparator (100) but via an auxiliary filter (242), and a third, positive input is connected to the output of the summing device via a delay circuit (243), the signal $\varphi_0$ being available at the output of said summing device (241).

5. A phase-locked loop as claimed in Claim 4, characterized in that it is a digital loop, that the transfer function of the auxiliary filter (242) is equal to, or constitutes an approximation of the transfer function of the loop, the loop being in the closed state, and in that the delay caused by the delay circuit (243) is equal to an integral number of sampling periods.

6. A phase-locked loop as claimed in claim 5, characterized in that the loop filter (300) is a microprocessor.

7. A phase-locked loop as claimed in Claim 6, characterized in that the microprocessor controls the performances of all the functions of said loop.

**Patentansprüche**

1. Phasenkomparator (100), der ein sinusförmiges Eingangssignal mit der Phase $\phi_E$ und ein sinusförmiges Signal mit der Phase $\phi_S$ zum Vergleichen mit diesem Eingangssignal zugeführt bekommt, dadurch gekennzeichnet, dass diesem Komparator eine Hilfsstufe (200) zugeordnet ist, die einerseits aus Mitteln (210, 240) besteht, zur Verringerung eines vorbestimmten Wertes der Phasendifferenz zwischen den beiden Eingängen des Komparators (100) und andererseits aus Mitteln (220, 230) zum Wiederherstellen des genannten Wertes an dem Ausgang der genannten Hilfsstufe (200), wobei diese Hilfsstufe (200) das Ausgangssignal des Komparators (100) und das zu vergleichende Signal erhält, und einerseits ein Ausgangssignal der genannten Wiederherstellungsmittel (220, 230) und andererseits zur Schleifenbildung ein Ausgangssignal der genannten Mittel (210, 240) zur Verringerung der Phasendifferenz liefert.

2. Phasenriegelschleife mit einem Phasenkomparator, einem Schleifenfilter (300) und einem Oszillator (400) zum Ermitteln der Phasendifferenz zwischen dem Eingangssignal und dem Ausgangssignal des Oszillators, zum zu dem Oszilator Übertragen der genannten Phasendifferenz und zum Ausfiltern derselben, und zum dem Phasenkomparator Liefern eines Signals, dessen Frequenz in dem Sinne einer Verringerung der genannten Phasendifferenz korrigiert worden ist, dadurch gekennzeichnet, dass der Phasenkomparator mit der Hilfsstufe (200) dem Anspruch 1 entspricht.

3. Phasenriegelschleife nach Anspruch 2, dadurch gekennzeichnet, dass die Mittel zur Verringerung der Phasendifferenz einen ersten Addierer (210) aufweisen, der einerseits ein Eingangssignal $\phi_S$ vom Oszillator und andererseits ein Phasendifferenzverringerungssignal $\phi_0$ erhält und zu dem Komparator die Grösse $(\phi_S + \phi_0)$ überträgt, dass die Wiederherstellungsmittel einen zweiten Addierer (220) aufweisen, der an einem ersten Eingang das Ausgangssignal des Komparators (100) erhält und an einem zweiten Eingang das Eingangssignal $\phi_0$ des genannten ersten Addierers, und zwar mittels Verzögerungsmittel für das Signal $\phi_0$.

4. Phasenriegelschleife nach Anspruch 3, dadurch gekennzeichnet, dass das Signal $\phi_0$ von einer Generatorschaltung geliefert wird, die einen Summenerzeuger (241) aufweist, von dem ein erster postitiver Eingang unmittelbar mit dem Ausgang des Komparators (100) verbunden ist, wobei ein zweiter, negativer Eingang des Summenerzeugers ebenfalls mit dem Ausgang des Komparators (100) verbunden ist, aber über ein Hilfsfilter (242), und wobei ein dritter, positiver Eingang mittels einer Verzögerungsschaltung (243) mit dem Ausgang des Summenerzeugers verbunden ist, wobei das Signal $\phi_0$ an dem Ausgang des genannten Summenerzeugers (241) verfügbar ist.

5. Phasenriegelschleife nach Anspruch 4, dadurch gekennzeichnet, dass sie digital ist, dass die Übertragungsfunktion des Hilfsfilters (242) bei geschlossener Schleife der der Schleife entspricht oder der der Schleife annähert, und dass die durch die Verzögerungsschaltung (243) herbeigeführte Verzögerung einer ganzen Anzahl Abtastperioden entspricht.

6. Phasenriegelschleife nach Anspruch 5, dadurch gekennzeichnet, dass das Schleifenfilter (300) ein Mikroprozessor ist.

7. Phasenriegelschleife nach Anspruch 6, dadurch gekennzeichnet, dass der Mikroprozessor alle Funktionen der genannten Schleife steuert.

EP 0 159 072 B1

FIG.1

FIG.2

FIG.3

1